(19)

Europäisches
Patentamt
European
Patent Office
Office européen
des brevets

(11) **EP 2 175 314 A1**

(12) **EUROPEAN PATENT APPLICATION**

(43) Date of publication:
**14.04.2010 Bulletin 2010/15**

(51) Int Cl.:
*G02F 1/13357* (2006.01)  *H01L 33/50* (2010.01)

(21) Application number: **09172652.1**

(22) Date of filing: **09.10.2009**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(30) Priority: **13.10.2008  TW 97139141**

(71) Applicant: **Advanced Optoelectronic Technology Inc.**
**No.13, Gongye 5th Road**
**Hsinchu Industrial Park**
**Hukou Township**
**Hsinchu County 303 (TW)**

(72) Inventors:
• **Tseng, Wen Liang**
  **Hukou Township,**
  **Hsinchu County 303 (TW)**
• **Lin, Hsin Chiang**
  **Hukou Township,**
  **Hsinchu County 303 (TW)**

(74) Representative: **2K Patentanwälte Blasberg**
**Kewitz & Reichel**
**Partnerschaft**
**Corneliusstraße 18**
**60325 Frankfurt am Main (DE)**

(54) **Method and system for designing a white-light phosphor-converted LED**

(57) A system and method for configuring a LED for back lighting a LCD with a high NTSC ratio is provided by using an algorithm to compute the optimum concentration of multiple phosphors so as to obtain white light similar to blackbody radiation of a given temperature and having a large color gamut with respect to the NTSC standard colour gamut.

FIG. 6

**Description**

**BACKGROUND OF THE INVENTION**

(A) Field of the Invention

The present invention relates to an LED BLU (LED Back Light Unit), and more particularly, to a method and a system for configuring an LED BLU with high NTSC (National Television System Committee).

(B) Description of the Related Art

Light emitting diodes (LED) are electrical devices capable of transforming electric energy into optical energy and having characteristics similar to diodes. An LED with direct current generates stable illumination, while an LED with alternating current generates flashes with a frequency dependent on the frequency of the alternating current. When an external voltage is applied to an LED, electrons and electron holes may pair within the LED and accordingly transform the energy into the lights emitted.

Most LEDs are compositions of III-arsenide, III-phosphide, III-nitride, or II-VI semiconductor compounds. Different materials generate photons carrying different energy. Accordingly, different kinds of wave, spectrum, and color of light can be controlled by altering the composition of such materials. By controlling the materials, the optoelectronic industry has produced LEDs with different wavelengths ranging from infrared rays to blue rays, and violet-ray and ultraviolet-ray LEDs are currently under development. The aforesaid LEDs are monochrome or single-frequency LEDs. White light LEDs, unlike the aforesaid single-frequency LEDs, are characterized by a frequency distribution within the visible spectrum range. Currently, a white light LED may be a multi-chip type LED or a single-chip LED.

A multi-chip LED is a composition of red, green, and blue LED chips and generates white light by mixing these three colors through a lens. The multi-chip LED has the advantage of high luminous efficiency and flexibility for adjusting colors, but it requires greater effort to design circuits for each individual chip and presents difficulty in controlling the lifespan of the LED. Part of the difficulty is attributed to the decay rate and the lifespan differences among such three chips.

Single-chip LED types use three methods to generate white light. The first method, a typical one, directs a blue ray generated by a blue light LED toward yellow phosphor and thereby stimulates the yellow phosphor to generate white light. Adjusting the intensity of the blue ray and the concentration of the yellow phosphor may control the CIE value of an LED, as long as an appropriate wavelength of blue ray is selected for the yellow phosphor. This type of white light LED, however, has a low General Color Rendering Index (Ra) due to the low intensity of the red color. If such LED is adopted as an auxiliary light source for digital cameras, the picture taken, especially the subject's face, generally appears pale. Therefore, the industry is currently endeavored to develop a white light led with high CRI (color rendering index).

The second method, to offset the low red intensity, directs a blue ray generated by an LED toward green and red phosphors or directs the blue ray toward green and yellow phosphors so as to improve CRI value of a white light LED. The third method directs an ultraviolet ray generated by an LED toward green, red, and blue phosphors to generate white light led.

As mentioned above, red phosphors or two or more kinds of phosphors may be adopted to manufacture an LED BLU with high NTSC. In the sense of the present application NTSC represents the color saturation, so that the term "high NTSC" means in particular high color saturation. When combining two phosphors to generate a mixed-emitting light source with a specific CIE value, three factors must be adjusted simultaneously. The factors include the concentration of the two phosphors and the intensity of the light source. Therefore trial-and-error experimentation is necessary for adjusting the concentration of phosphor and the intensity of the blue LED to improve the chromaticity saturation or the NTSC of an LED used as the backlights of BLU.

Additionally, the emitting spectrum of an LED is relevant to temperature. When the junction temperature rises higher, the peak of the wavelength of the emitting spectrum of an LED moves toward longer wavelengths. Therefore, the emitting frequency of an LED may be changed and the temperature of components may rise higher if the LED functions continuously for a long time. In addition, the LEDs manufactured may have a spectrum distribution and should be sorted by bin code. The manufacturing cost is thus increased substantially.

U.S. patent Pub. No. US2006/0290624 discloses a method to solve this issue. The method first adjusts one color of the RGB, such as green, and provides two LEDs with one of the two LEDs having a wavelength longer than that of green light and the other having a wavelength shorter than green light. The mixed-emitting of the two LEDs can be controlled by a controlling circuit to generate a particular wavelength for green light. When a detector identifies the change of the emitting frequency due to the continuous functioning, the control circuit will adjust the intensity of the two LEDs such that the particular wavelength of the green light remains unchanged. Where one of the RGB colors can be adjusted, any LEDs with RGB colors can be adjusted.

The method can be implemented theoretically, but manufacturing cost will increase substantially. First, such implementation takes three controlling circuits and three detectors for RGB colors, and each color LED requires at least two LEDs for adjustment. Therefore, an LED with RGB colors should require at least six LEDs for adjustment and the cost of the manufacture and management accordingly increase substantially. Second, the lifespan of each LED is different and the lifespan of the product may become an issue.

Another method uses an LED to stimulate the emitting of phosphors. Compared with the method disclosed by U.S. patent Pub. No. US2006/0290624. when the emitting of phosphors has the following advantages as set forth below. When the emitting spectrum of an LED is changed, the light source for stimulating the phosphors is changed but the stimulated spectrum of phosphors is unchanged as long as the emitting spectrum of the LED is within a particular spectrum range for the phosphor to absorb. Utilizing phosphors seems a good choice.

As disclosed by TW patent publication number 200627678, an ultra-violet or violet LED may be adopted to stimulate RGB phosphors. This method can substantially improve the CRI of an LED when the LED functions as the light source and can improve the chromaticity or NTSC when the LED is used as the backlight of an LCD display.

As disclosed by TW patent publication number 200830580, a red phosphor may be adopted to improve NTSC. The red phosphor used can be $CaAlSiN_3$:Eu, and the green phosphor used can be $(Ba_xSr_{1-x})_2SiO_4$:Eu(x≥0.5).

As shown in the methods mentioned above, multiple phosphors may be used to improve the NTSC of an LED. Several issues, however, remain unresolved. First, the concentration of phosphors requires trial and error, and thus consumes time. Second, the spectra to be filtered differ substantially due to the wide varieties among the color filters manufactured. To most LED manufactures, the concentration of different kind of phosphors should be adjusted to improve saturation, and such and such adjustment of phosphor concentration is very time-consuming.

As more kinds of phosphors are developed for the market, the time required by utilizing such phosphors or more than two kinds of phosphors for developing or configuring LED BLU with high NTSC becomes longer, and that becomes a great challenge for making a product commercially available.

## SUMMARY OF THE INVENTION

Based on the background of the invention and the need of the industry, the present invention provides a method for configuring an LED BLU with high NTSC. The first step is to calculate a standard spectrum wherein the standard spectrum is a visible spectrum radiated from a blackbody with a first color temperature. The second step is to provide an emission spectrum of an LED, a first phosphor, and a second phosphor. The third step is to adjust the concentration of the first phosphor and the second phosphor to generate a first mixed-emitting spectrum similar to the standard spectrum. The first mixed-emitting spectrum after the color separation by a color filter is represented by RGB chromaticity coordinate values, and the area formed by the RGB chromaticity coordinate values can be calculated. A white light chromaticity coordinate value based on the combination of the RGB chromaticity coordinate values can be calculated as well.

The present invention provides another method for configuring an LED BLU with high NTSC. The first step is to calculate a standard spectrum wherein the standard spectrum is a visible spectrum radiated from a blackbody with a first color temperature. The second step is to provide an emission spectrum of an LED, a first phosphor, and a second phosphor. The third step is to adjust the concentration of the first phosphor and the second phosphor to generate a first mixed-emitting spectrum based on the standard spectrum. The first mixed-emitting spectrum after a color separation by a color filter can be represented by RGB chromaticity coordinate values and an area formed by the RGB chromaticity coordinate values can be calculated. A white light chromaticity coordinate value based on the combination of the RGB chromaticity coordinate values can also be calculated.

The present invention provides a system for configuring an LED BLU with high NTSC. The system includes a first database, a standard color temperature spectrum generator, a first blending unit, a second blending unit, a spectrum comparison unit, a second database, a filtering unit, and a color saturation calculation unit. The first database provides an emission spectrum of an LED, an emission spectrum of a first phosphor, and an emission spectrum of a second phosphor. The standard spectrum generator generates a visible spectrum radiated from a blackbody with a first color temperature. The first blending unit calculates a mixed-emitting spectrum of the LED, the first phosphor, and the second phosphor stored in the first database, wherein the mixed-emitting spectrum is a first mixed-emitting spectrum. The spectrum comparison unit compares the first mixed-emitting spectrum with the standard spectrum generated by the standard color temperature spectrum generator. The second database stores spectra filtered by color filters. The filtering unit calculates RGB chromaticity coordinate values of the first mix-emitting spectrum based on the spectra filtered by color filters stored in the second database. The color saturation calculation unit calculates the area formed by the RGB chromaticity coordinate values of the first mixed-emitting spectrum. The second blending unit calculates a white light chromaticity coordinate values based on a combination of the RGB chromaticity coordinate values.

The present invention provides another method for configuring an LED BLU with high NTSC. The first step is to adjust the concentration of multiple phosphors to generate a spectrum of a mixed-emitting LED similar to an emission spectrum radiated from a blackbody with a first color temperature. The second step is to generate RGB chromaticity coordinate values which represent the spectrum of the mixed-emitting LED after a color separation by a color filter and the area formed by the RGB chromaticity coordinate values to satisfy the predetermined values.

The present invention further provides another method for configuring an LED BLU with high NTSC by adjusting the concentration of multiple phosphors based on two approximations. The first step is to adjust the concentration of multiple phosphors such that the emission spectra of the multiple phosphors are similar to an emission spectrum radiated from a blackbody. The second step is to modify the concentration of multiple phosphors based on RGB chromaticity coordinate values representing the emission spectra of the multiple phosphors after a color separation by a color filter and based on the area formed by the RGB chromaticity coordinate values.

The aforesaid steps, methods, and system for calculating the standard spectrum are based on Planck formulas. The aforesaid first mixed-emitting spectrum is generated by stimulating the first phosphors and the second phosphors. The first phosphor can be $CaSc_2O_4$:Ce, $(MgCaSrBa)_2SiO_4$:Eu, $Ca_3Sc_2Si_3O_2$:Ce, $(Ca_{1.47}Mg_{1.5}Ce_{0.03})(SC_{1.5}Y_{0.5})Si_3O_{12}$, or $(Ca_{2.97}Ce_{0.03})Sc_2(Si,Ge)_3)O_{12}$. The second phosphor can be $CaAlSiN_3$:Eu, $(CaEu)AlSiN_3$, $(SrCa)AlSiN_3$:Eu, or $SrGa_2S_4$:Eu. The present invention can further comprise a third phosphor and the emission spectrum of the third phosphor.

One purpose of the present invention is to utilize software algorithms to efficiently adjust the concentration of multiple phosphors for configuring an LED BLU with high NTSC and to reduce the cost attributed to the time consumed for trial and error.

## BRIEF DESCRIPTION OF THE DRAWING

FIG.1 illustrates a CIE 1931 chromaticity diagram;

FIG.2 illustrates an NTSC standard and the chromaticity coordinate values of an ordinary LED;

FIG. 3 illustrates a flowchart of a method for deriving an LED BLU with high NTSC based on a calculation of the concentration of multiple phosphors;

FIG.4 illustrates a flowchart of a method for configuring an LED BLU with high NTSC;

FIG.5 illustrates a block diagram of a system for configuring an LED BLU with high NTSC;

FIG. 6 illustrates a flowchart of a process for configuring a white light LED with high CRI;

FIG. 7 illustrates a block diagram of a system for configuring a white light LED with high CRI by determining the similarity of emission spectra;

FIG. 8 illustrates the mixed-emitting spectrum of an LED and two different kinds of concentration of phosphors;

FIG. 9 illustrates a filtered spectrum of a color filter;

FIG. 10 illustrates a block diagram of a system for configuring a white light LED with high CRI based on CRI comparison;

FIG. 11 illustrates a block diagram of a system for configuring a white light LED with high CRI; and

FIG. 12 illustrates an LED BLU with high NTSC of the present invention, the NTSC standard, and the CIE 1931 chromaticity coordinate values of an ordinary LED.

## DETAILED DESCRIPTION OF THE INVENTION

The present invention is related to an LED BLU with high NTSC and its method and system. For the purpose of understanding the present invention thoroughly, the descriptions below illustrate detailed steps and the compositions thereof. Clearly, the embodiment of the present invention is not limited to the particular method or the system familiar to those skilled in the art of LED BLU with high NTSC. On the other hand, the ordinary skills in the art are not illustrated to avoid unnecessary limitations on the present invention. The preferred embodiments are illustrated below but the present invention may be utilized in other practices and should not be limited by such illustrated embodiments. The scope of the present invention should be interpreted in light of the claims.

As discussed above, one of the key elements to generate a white light is phosphor, a fluorescent material. As soon as the phosphor body is stimulated by photons, electrical fields, or electron rays, the electrons within the phosphor body acquire enough energy to jump to the excited states. While the electrons in the excited state are generally unstable, the electrons may return to ground state radiatively or non-radiatively through the process of relaxation. The radiative relaxation generates photons or rays, and the non-radiative relaxation causes the lattice of the phosphor to vibrate and thus generate heat. If the wavelength of the rays is within visible range, human eyes can detect such rays. The wavelengths of the rays are relevant to the electron transitions between the energy states or the energy levels.

Phosphor is mainly composed of host lattices (H). For example, ZnS is the host lattice material of $ZnS:Cu^{2+}$. By adding or doping some other foreign ions in the host lattice, the foreign ions become ready to be stimulated and are known as the "activator" or the emission center of the fluorescent lattice. Some phosphor material may be doped by a second kind of foreign ion, and is known as a sensitizer or co-activator. If the host lattice and the activator are properly controlled, the phosphor may generate various kinds of wavelengths. The host lattices of phosphors available on the market are Sulfides, Oxides, Oxysulfides, Nitrides, Oxynitrides, Garnet, and Silicates.

People generally perceive white light to appear the same as sunlight. White light, however, is a continuous spectrum ranging from 400nm to 700nm. It can be categorized by visible colors of red, orange, yellow, green, blue, indigo, and violet. While a normal LED generates only monochrome lights, a white light LED requires a mixture of at least two complementary colors. One of the technical concerns of white light manufacturing is the LED's ability to display the colors of an object precisely. Such display is known as Color Rendering. Better Color Rendering allows the LED color to be closer to the actual color or the natural color. The Color Rendering Index (CRI) of a white light LED is relevant to the chips of LED, phosphor, and the material used. The phosphor used and the chips of LED function differently under different color temperatures.

Color Temperature is measured by a method of heating up a metal with a characteristic similar to a blackbody, and the color emitted from the metal varies as the temperature changes. The temperature affects on the color of the light source is defined as the color temperature of such light source. For example, when an iron is heated, the first color to appear is red, next is orange, followed by blue and white. Researchers determine the relation between color and temperature by a series of spectra. The wavelength is represented on the x axis, and the radiation flux is indicated on the y axis. The radiation flux of an iron at different temperatures can be represented by a diagrammatic curve because the y axis may reflect different radiation fluxes based on different wavelengths. For example, when the iron turns red, the radiation flux of red outweighs other colors. At this point the diagrammatic curve has a peak, and as the temperature rises, the peak moves toward a shorter wavelength and the radiation flux of all wavelengths increases. When the iron's temperature is close to 4200K, the peak of the radiation flux is close to a wavelength of red colors, and the iron appears as a red object. As the temperature rises higher to 4800K, the peak of the radiation flux move toward a shorter wavelength close to that of orange, and the iron appears as an orange object. When the temperature approaches 5800K, the peak of the radiation flux is close to yellow-green.

The color temperature and blackbody radiation are estimated using Kelvin temperature. Blackbody radiation is calculated by Kelvin temperature K= +273 as a starting point. When a blackbody can absorb all energy without any loss and is capable of transforming the energy to the form of light, the blackbody's color may vary when the temperature is changed. For example, the color of a blackbody with a temperature around 500-550 is dark red, but the color becomes yellow when the temperature goes up to 1050-1150 . Accordingly, the color of a light source is relevant to the heat or energy absorbed by the blackbody, and the color temperature may be represented by Kelvin temperature. The blackbody's color can be white if the blackbody emits photons with all visible wavelengths. The tungsten lamp, a typical example from daily use, is close to such a blackbody. Based on the aforesaid relation between color and a blackbody's temperature, any color temperature of a light source may be represented by the temperature of blackbody and by a corresponding point in Planck's Locus of a chromaticity diagram. The curve of a blackbody changes with temperature. Accordingly, any two blackbodies with the same temperature shall have the same color.

Natural light source varies with color, time, weather, observer, season, and geographical location, and therefore is inconvenient for color definitions. The Commission International de l'Eclariagre, abbreviated as CIE, therefore defines various standard light sources similar to the natural light source.

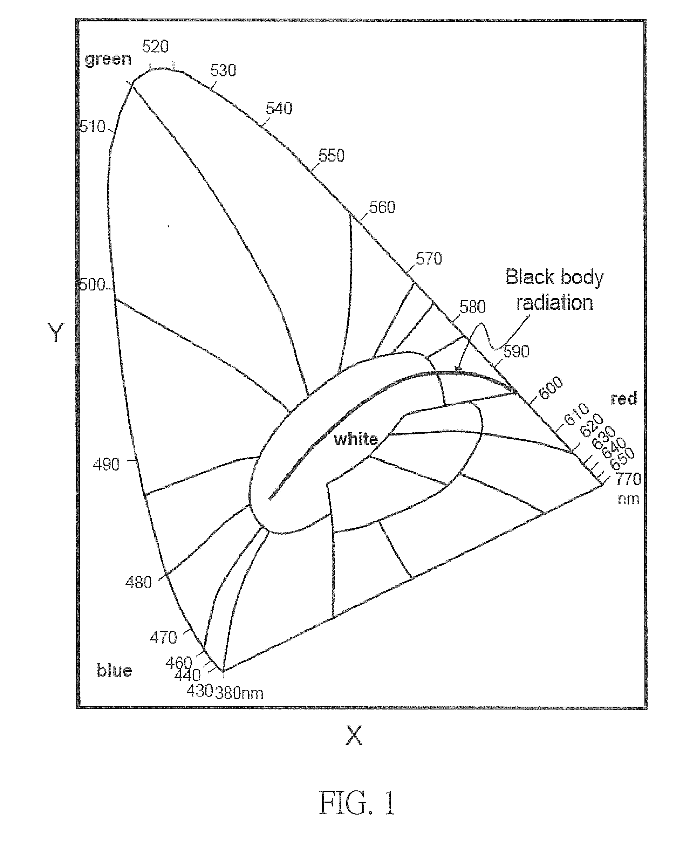

CIE further defines a 1931 standard observer based on a mathematical model for eyesight and an experiment for color comparison. Such norm is defined by three curves to represent a color comparison function, and is also known as the CIE 1931 standard color matching function. As shown in FIG. 1, x represents the measured red color, while y represents the measured green of the CIE 1931 chromaticity diagram. The wavelengths within the horseshoe-shaped boundary represent all visible colors, and the wavelengths on the horseshoe boundary represent saturated monochrome wavelengths. The system utilizes x, y, and z to represent red, green and blue; each point in the diagram represents one color. While the diagram shows x and y only, z can be derived by the equation x+y+z=1. The point in the middle of the coordinate (0.33,0.33) represents white light. The edge of each color space represents spectrum colors, and the number on the boundary represents the wavelengths of spectrum colors. The boundary represents the maximum saturation of each spectrum color, and its contour represents all visible colors. Since all monochrome wavelengths are located on the tongue-shaped curve, such curve is a locus of monochrome and the numbers marked besides it are the wavelengths corresponding to each monochrome wavelength (or spectrum color). The natural and actual colors are within the boundary of the curves.

NTSC is a color TV broadcast standard established by National Television System Committee, abbreviated as NTSC. NTSC is a synchronized standard with 29.97 fps (frames per second), 525 scan lines, a screen ration 4:3, and a resolution of 720x480. The color signal of this standard can be adjusted by balance modulation and quadrature modulation to solve the compatibility problem between color TV broadcast and mono-chromaticity TV broadcast.

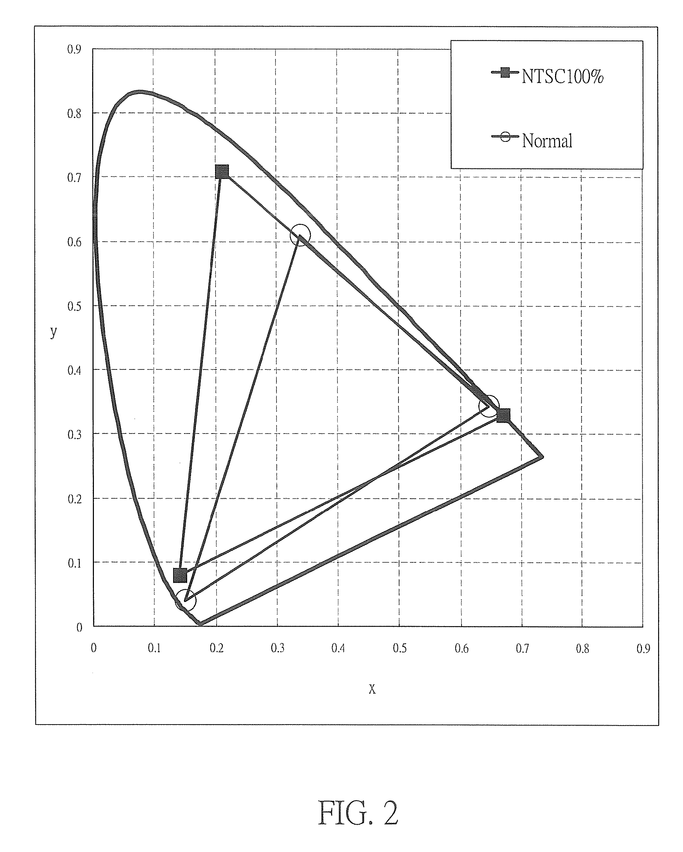

FIG. 2 represents a CIE 1931 chromaticity coordinate of an LED and the NTSC standard. Colors defined by NTSC can be represented by the area formed by RGB values in the chromaticity coordinate, and as shown in FIG. 2, the area is formed by the three rectangular spots. The color saturation of a white light source based on the LED backlights of an LCD display can be represented by an area in FIG. 2. Such area is smaller than the area representing the colors defined by the NTSC standard and therefore provides inferior color saturation.

The calculation of a blackbody radiation was proposed by J. Stefan in 1879 as follows: $E=aT^4$, where E is the total energy, and T is the absolute temperature; the formula is called the Stefan-Boltzmann Law.

In 1893, Wien discovered that wavelength is proportional to temperature and came up with the Wien Displacement Law: $T\lambda_{max}$=constant. In 1896, Wien further proposed a formula based on experiments: $pv=\alpha v^3 exp(\beta v/T)$, where pv is radiant energy density, $v$ is frequency, T is Kelvin temperature, and $\alpha$ and $\beta$ are constants.

In 1900, J.W. Rayleigh and J.H. Jeans used classic mechanics and statistical physics to derive a blackbody radiation formula, the Rayleigh-Jeans Law:

$$\rho_\nu = \frac{8\pi\nu^3}{c^3}\kappa_B T$$

where c is the velocity of light, and K is Boltzmann's constant.

This formula matches the experimental results when the frequency is low. However, as $\nu\to\infty$ and $\rho_\nu\to\infty$, the formula clearly fails which is known as ultraviolet catastrophe.

After more detailed experiments, Wien deviated from the experimental data in the long wavelength portion. In 1900, the German physicist M. Plank came up with a formula to match the experimental data as follows:

$$\rho_\nu = \frac{8\pi h\nu^3}{c^3}\frac{1}{\exp(h\nu/\kappa_B T)-1}$$

or

$$\rho_\lambda = \frac{8\pi hc}{\lambda^5}\frac{1}{\exp(hc/\lambda\kappa_B T)-1}$$

where h is Planck's constant, $6.626\times10^{-34}$ J·s. Planck's theory has successfully explained the Rayleigh-Jeans Law, the Wien Displacement Law, and the Stefan-Boltzmann law.

The manufacturing of a white light LED with high CRI is time-consuming and costly due to the cross-tests adopted and the various factors affecting the CRI value. Factors include different color temperature, the chips of an LED, and the phosphors. The present invention based on a Plank's law derived from blackbody radiation and the theorem of blackbody radiation sets forth a method and system for configuring a white light LED with high CRI by adjusting multiple phosphors.

The present invention is relevant to a method of utilizing two steps of approximation to determine the concentration of various phosphors for configuring an LED BLU with High NTSC. The first approximation is to adjust the concentration of various phosphors for a radiation close to blackbody radiation. The second approximation is to determine the color saturations and the chromaticity coordinate values of a white light after a color separation by a color filter.

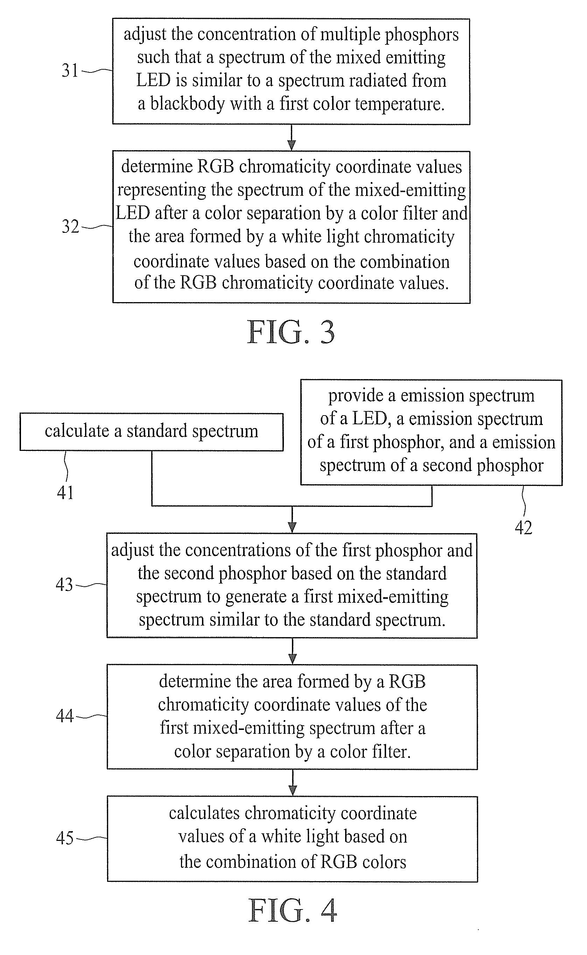

As shown in FIG. 3, the present invention discloses a method for calculating multiple phosphors configuring an LED BLU with high NTSC. The first step 31 is to adjust the concentration of multiple phosphors such that a spectrum of the mixed emitting LED is similar to a spectrum radiated from a blackbody with a first color temperature. Such an LED can be an ultraviolet LED, a violet LED, or a blue LED. Multiple phosphors can be comprised of two or more kinds of phosphors, and the use of each phosphor is based on the color of light to be generated by the LED. For example, an ultraviolet or violet LED requires three kinds of phosphors to generate a mixed-emitting white light. A blue LED, however, requires two kinds of phosphors for configuring a white light LED with high CRI. The second step 32 is to determine RGB chromaticity coordinate values representing the spectrum of the mixed-emitting LED after a color separation by a color filter and the area formed by a white light chromaticity coordinate values based on the combination of the RGB chromaticity coordinate values.

As shown in FIG. 3, the present invention discloses a method for configuring an LED BLU with high NTSC. A more detailed process is disclosed in FIG. 4. The first step 41 is to calculate a standard spectrum, wherein the standard spectrum is a visible spectrum radiated from a blackbody with a first color temperature. The second step 42 is to provide an emission spectrum of an LED, an emission spectrum of a first phosphor, and an emission spectrum of a second phosphor. The third step 43 is to adjust the concentration of the first phosphor and the second phosphor based on the standard spectrum to generate a first mixed-emitting spectrum similar to the standard spectrum. The fourth step 44 is to determine the area formed by RGB chromaticity coordinate values of the first mixed-emitting spectrum after a color separation by a color filter. A color filter is a kind of filter broadly used in LCD monitors to separate RGB colors. The larger the aforesaid area formed by the RGB chromaticity coordinates values, the better color saturations of the LCD monitors. This particular step is to inspect color saturation. If the color saturation is not as good as expected, the concentration of phosphors is adjusted. The fifth step 45 calculates chromaticity coordinate values of a white light based on the combination of RGB colors. When the chromaticity coordinate values of white light are incorrect, the concentrations of phosphors are adjusted. The chromaticity coordinate values of white light can be adjusted to satisfy the chromaticity coordinate values of a blackbody radiation with a predetermined color temperature. In FIG 4, only two kinds of phosphors are used to implement the present invention. Three kinds, four kinds, or five kinds of phosphors, however, may be used to implement the present invention.

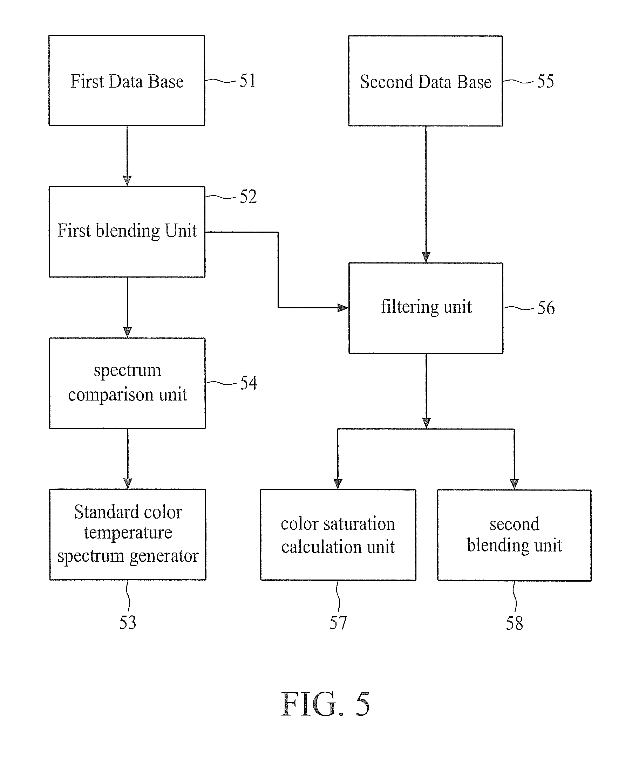

According to the procedure adopted in FIG. 4, another embodiment of the present invention provides a system for configuring an LED BLU with high NTSC. Referring to FIG. 5 includes a first data base 51, a first blending unit 52, a standard color temperature spectrum generator 53 and a spectrum comparison unit 54. The first data base 51 is to store an emission spectrum of an LED, an emission spectrum of a first phosphor, and an emission spectrum of a second phosphor. The first blending unit 52 is to calculate a mixed-emitting spectrum of the LED, of the first phosphor, and of the second phosphor stored in the first database 51. The mixed-emitting spectrum described above is a first mixed-emitting spectrum. The standard color temperature spectrum generator 53 is to generate a visible spectrum radiated from a blackbody with a first color temperature, and the spectrum comparison unit 54 is to compare the first mixed-emitting spectrum with the standard spectrum generated by the standard color temperature spectrum generator 53. When the spectrum comparison unit 54 finds the similarity between the first mixed-emitting spectrum and the visible spectrum radiated from a blackbody with a first color temperature, the data of first mixed-emitting spectrum is transmitted to the next step. If the spectrum comparison unit 54 finds dissimilarity, the step returns to the first blending unit 52 to recalculate a first mixed-emitting spectrum until a similarity is found.

In FIG. 5, a second database 55 is configured to store a filtered spectrum by a color filter; wherein the color filter is a filter used by LCD monitors to separate colors. The filtering unit 56 is to calculate the RGB chromaticity coordinate values of the first mixed-emitting spectrum by using the filtered spectrum. The color saturation calculation unit 57 is to calculate the area formed by the RGB chromaticity coordinate values mentioned above. If the area is smaller than the area defined by NTSC or smaller than an area of color saturation commercially defined, the step returns to first blending unit 52 to re-calculate the first blending spectrum until the predetermined requirement of the color saturation calculation unit 57 is satisfied. The second blending unit 58 is to calculate the chromaticity coordinate values of a white light based on the combination of a particular RGB values. When the chromaticity coordinate values of such white light deviated from a normally defined white light chromaticity coordinate value, the step returns to the first blending unit 52 to re-calculate the first blending spectrum until the second blending unit 58 satisfies the predetermined requirement of the color saturation calculation unit 57. In present inventions, the chromaticity coordinate values of a white light can be compliant with the blackbody radiation with a predetermined color temperature such as a white light chromaticity coordinate values with a color temperature of 6500K.

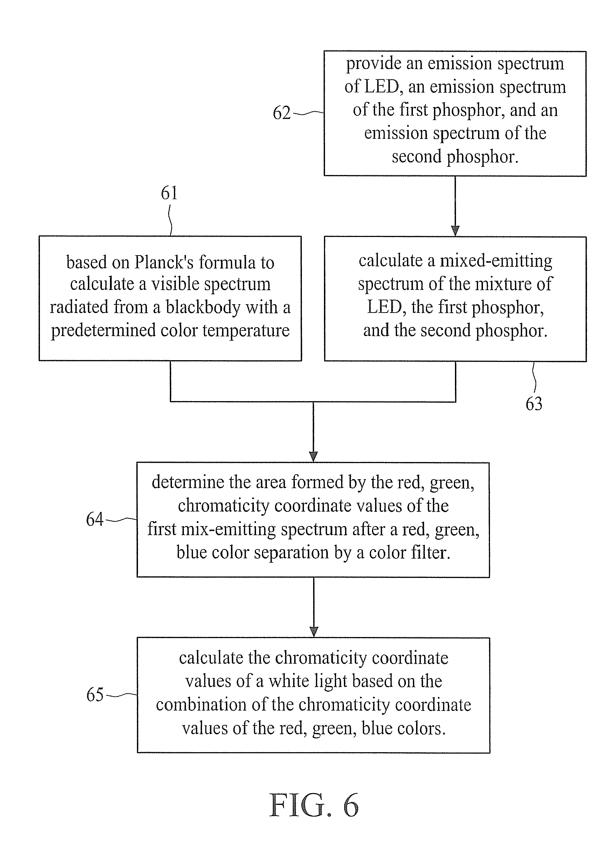

The following figures disclose a preferred embodiment of the present invention. FIG. 6 discloses a process for configuring a high CRI white light LED. In the first step 61, Planck's formula:

$$\rho_\lambda = \frac{8\pi hc}{\lambda^5} \frac{1}{\exp\left(hc / \lambda \kappa_B T\right) - 1} \quad (1)$$

is adopted to calculate a visible spectrum radiated from a blackbody with a predetermined color temperature. Rayleigh-Jeans, Stefan-Boltzmann, or Wien's formulas, however, may be used for a simplified method for calculating spectra of blackbody radiation. Based on Planck's formula, a visible spectrum of a blackbody may be derived from a particular color temperature (ranging from 2500K to 8000K). In this step, such visible spectrum of the color temperature of the blackbody is represented by $T_a(\lambda)$.

The second step 62 provides an emission spectrum of an LED, an emission spectrum of the first phosphor, and an emission spectrum of the second phosphor. When two kinds of phosphors are used, all kinds of emission spectra of the phosphors are provided. In this step, $L(\lambda)$ represents the emission spectrum of the LED, $P1(\lambda)$ represents the emission spectrum of the first phosphor, and $P2(\lambda)$ represents the emission spectrum of the second phosphor.

The third step 63 adjusts the concentration of the phosphors in accordance with the visible spectrum calculated in the first step and then calculates a mixed-emitting spectrum of the LED, the first phosphor, and the second phosphor. The calculation is illustrated below:

$$C_a(\lambda) = a \times L(\lambda + \Delta\lambda) + b \times P1(\lambda + \Delta\lambda) + c \times P2(\lambda + \Delta\lambda) \text{ and seek a set of } (a,b,c)$$

$$\text{that has the minimum value of } \sum_\lambda |T_a(\lambda) - C_a(\lambda)|^2. \qquad (2)$$

The mixed-emitting spectrum is represented by $C_a(\lambda)$, the intensity of the LED is represented by a, the concentration of the first phosphor is represented by b, and the concentration of the second phosphor is represented by c.

The above-described embodiments of the present invention are intended to be illustrative only. Those skilled in the art may utilize other functions or formulas to calculate the concentration of each phosphor and obtain a mixed-emitting spectrum $C_a(\lambda)$ as the first mixed-emitting spectrum.

The fourth step 64 is to determine the area formed by the red, green, and blue chromaticity coordinate values of the first mixed-emitting spectrum after a red, green, blue color separation by a color filter. First, the first mixed-emitting spectrum is separated into red, green, and blue colors in accordance with the filtered spectrum of a color filter. Second, CIE chromaticity coordinate values of red, green, and blue colors are calculated. The area formed by the CIE chromaticity coordinate values of RGB may be accordingly calculated, and such area is compared with the area defined by NTSC. For example, when such area is 75% of the area defined by NTSC, the color saturation is 75% of NTSC color saturation. In accordance with the algorithm of the present invention, the white light LED light source shall be at least 90% of NTSC, 95% of NTSC, or 100% of NTSC. Otherwise, the steps return to the third step 63 to readjust the concentration of phosphors or the proportional relationship thereof.

The fifth step 65 calculates the chromaticity coordinate values of a white light based on the combination of the chromaticity coordinate values of the red, green, and blue colors. The chromaticity coordinate values of a white light based on the combination of the red, green, and blue colors may deviate from the standard white light or a white light required by a specific commercial standard due to the RGB color separation by a color filter. Accordingly, the white light after combination should be inspected. Commercial standards may require the chromaticity coordinate values of the white light with the color temperature of a particular blackbody radiation. For example, the color temperature of the white light may be required to satisfy the chromaticity coordinate values of a white light with a color temperature of 6500K or with a color temperature of 6000K.

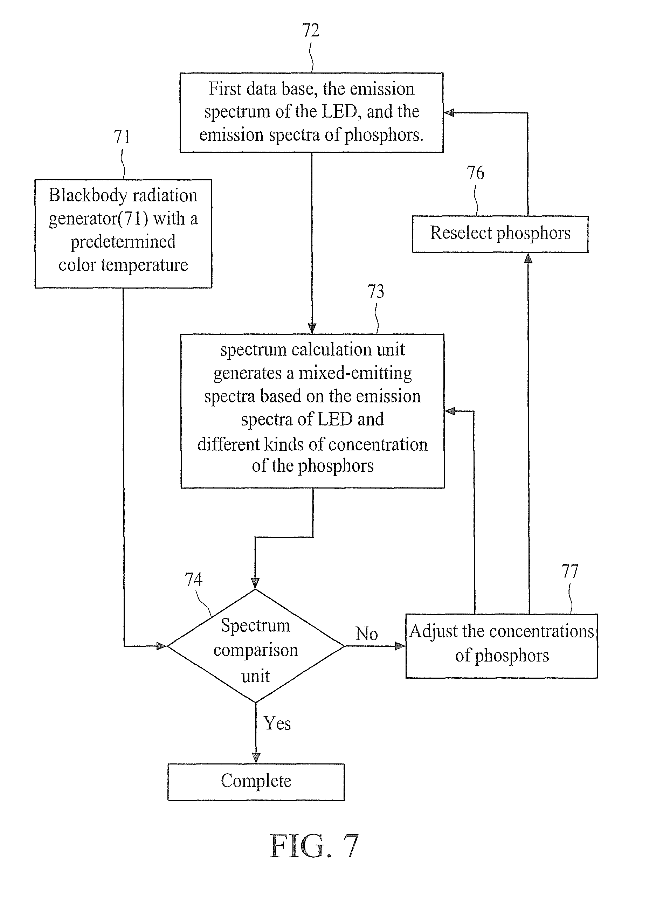

As shown in FIG. 6, the present invention provides a block diagram for configuring a white light LED with high CRI. As shown in FIG. 7, a blackbody radiation generator 71 with a predetermined color temperature may generate a visible spectrum radiated from a blackbody with a predetermined color temperature. The color temperature ranges from 1500K to 8000K. A first database 72 is adopted to store an emission spectrum of an LED and emission spectra of phosphors. The emission range of an LED with UVA light is 365nm - 380nm, while the emission range for an LED with violet light is 380nm - 420nm and an the emission range for an LED with blue light is 420nm - 470nm. The wavelength of an emission generated by a phosphor is between 480 and 580nm. The phosphor can be silicates or oxides, such as:

$CaSc_2O_4$:Ce(516nm),

$(MgCaSrBa)_2SiO_4$:Eu(525nm),

$Ca_3Sc_2Si_3O_{12}$:Ce(455-507nm),

$(Ca_{1.47}Mg_{1.5}Ce_{0.03})(Sc_{1.5}Y_{0.5})Si_3Ol_2$(455nm), or

$(Ca_{2.97}Ce_{0.03})Sc_2(Si,Ge)_3O_{12}.$

The phosphor can be nitrides or sulfides and with emission wavelength between 600nm and 650nm such as:

$CaAlSiN_3:Eu(650nm),$

$(CaEu)AlSiN_3(648nm),$

$(SrCa)AlSiN_3:Eu(630nm),$ or

$SrGa_2S_4:Eu(645nm).$

Those skilled in the art may utilize other kinds of phosphor to implement the present invention, such as garnetite or nitrogen oxides.

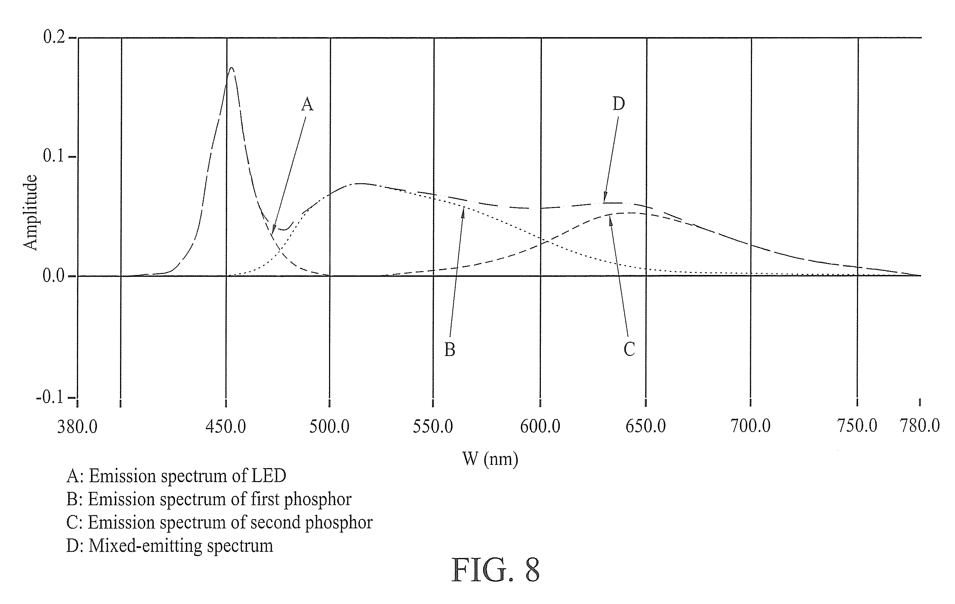

A spectrum calculation unit 73 derives the emission spectrum of the LED and the emission spectra of two kinds of phosphors from the first database 72 and determines the concentration of phosphors. Based on the concentration of the phosphors determined, the spectrum calculation unit 73 generates a mixed-emitting spectrum. As shown in FIG. 8, Curve A represents the emission spectrum of the LED, Curve B and Curve C represent the emission spectra of the phosphors, and Curve D represents the mixed-emitting spectrum after mixturing.

The spectrum comparison unit 74 is configured to determine the similarity between the spectra of the mixed-emitting spectrum and the visible spectrum of a blackbody radiation with a predetermined color temperature. If the result of the similarity comparison between mixed-emitting spectrum and the visible spectrum is "Yes," an appropriate white light emitting spectrum is generated. If the result is "No," the concentration of phosphor is adjusted 76 or the phosphor is reselected 77 until the similarity is found between the spectra of the mixed-emitting spectrum and the visible spectrum of the blackbody radiation with a predetermined color temperature.

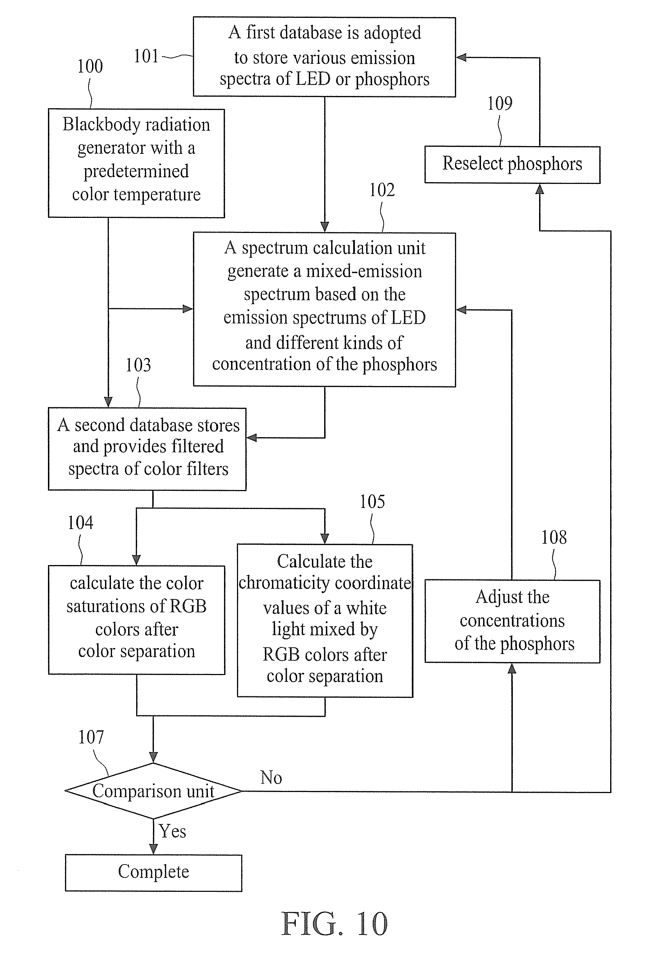

The present invention further discloses a block diagram for configuring a white light LED with high CRI as shown in FIG. 10. A blackbody radiation generator 100 with a predetermined color temperature provides a visible spectrum radiated from a blackbody with a predetermined color temperature. The color temperature ranges from 1500K to 8000K. A first database 101 is adopted to store various emission spectra of LEDs and of phosphors. The emission range of an LED with UVA light is 365nm - 380nm, while the emission range of an LED with violet light is 380nm - 420nm and the emission range of an LED with blue light is 420nm - 470nm. The wavelength of an emission generated by a phosphor is between 480nm and 580nm. The phosphor can be silicates or oxides, such as:

$CaSc_2O_4:Ce(516nm),$

$(MgCaSrBa)_2SiO_4:Eu(525nm),$

$Ca_3Sc_2Si_3O_{12}:Ce(455-507nm),$

$(Ca_{1.47}Mg_{1.5}Ce_{0.03})(Sc_{1.5}Y_{0.5})Si_3Ol_2(455nm),$ or

$(Ca_{2.97}Ce_{0.03})Sc_2(Si,Ge)_3O_{12.}$

The phosphor can be nitrides or sulfides having emission wavelength between 600nm and 650nm such as:

$CaAlSiN_3:Eu(650nm),$

$(CaEu)AlSiN_3(648nm),$

$(SrCa)AlSiN_3:Eu(630mn),$ or

$SrGa_2S_4:Eu(645nm).$

Those skilled in the art may utilize other kinds of phosphor to implement the present invention such as garnetite or nitrogen oxides.

A spectrum calculation unit 102 calculates the emission spectrum of the LEDs and the emission spectra of two kinds of phosphors from the first database 101 to generate a mixed emission spectrum. A blackbody radiation generator 100 with a predetermined color temperature generates a visible spectrum radiated from a blackbody with a predetermined color temperature. The concentration of the phosphor may be adjusted based on the comparison of the visible spectra with the mixed emission spectra.

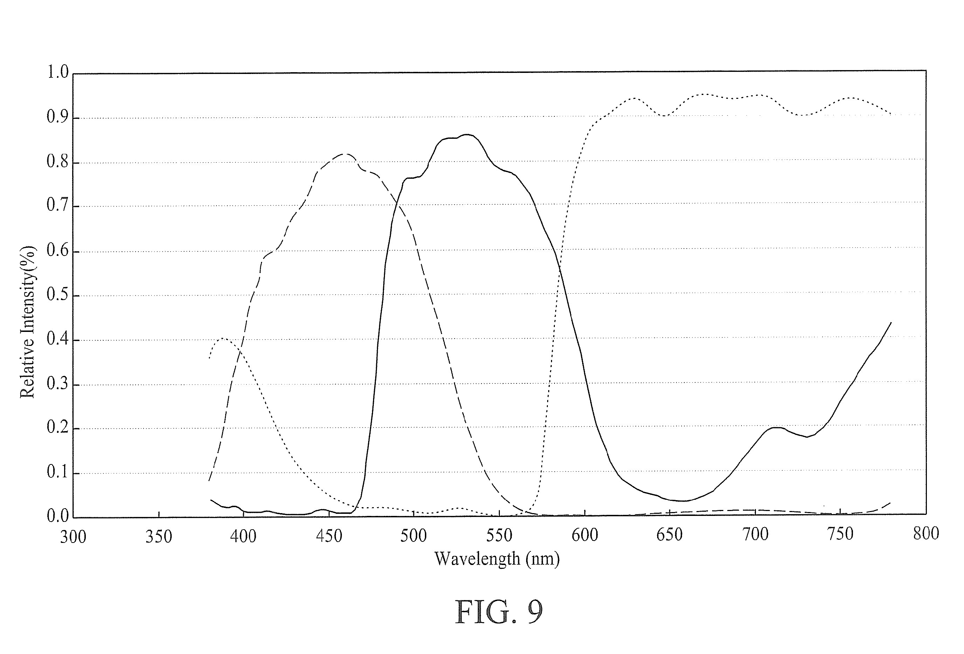

The second database 103 stores and provides filtered spectrum of color filters. Referring to FIG. 9, spectra of kinds of color filters are displayed, and a portion of the filtered spectrum of each color filter is interlaced. Due to the interlacing, the color saturation of a light source of an LED with high CRI will be reduced if the color filtered spectra are provided. One of the reasons is that part of the blue rays provided by such filtered spectra may become green lights, and thus each color of light source may affect the final colors. The calculated mixed-emitting spectrum becomes red, green, and blue colors after entering the second database 103. The data of such three colors is provide to the color saturation calculation unit 104 and blending calculation unit 105 to calculate the color saturations of the three colors after color separation and the chromaticity coordinate values of a white light based on a combination of such three colors after color separation.

The result of the calculation is then provided to the comparison unit 107 to determine whether such color saturations and such chromaticity coordinate values meet a predetermined requirement. If one of the conditions fails the predetermined requirement, the step returns to the first database 101 to reselect phosphors or returns to spectrum calculation unit 102 to adjust the concentration of phosphors such that the result provided by the color saturation calculation unit 104 and the blending calculation unit 105 meets a predetermined requirement. The conditions of color saturations can be predetermined to be 90% of NTSC, 95% of NTSC, or 100% of NTSC. The white lights after blending may become a standard white light or a white light that meets a particular commercial specification; wherein the particular commercial specifications may include a requirement that the chromaticity coordinate values of a white light meets the color temperature of a blackbody radiation, such as a color temperature of 6500K or 6000K.

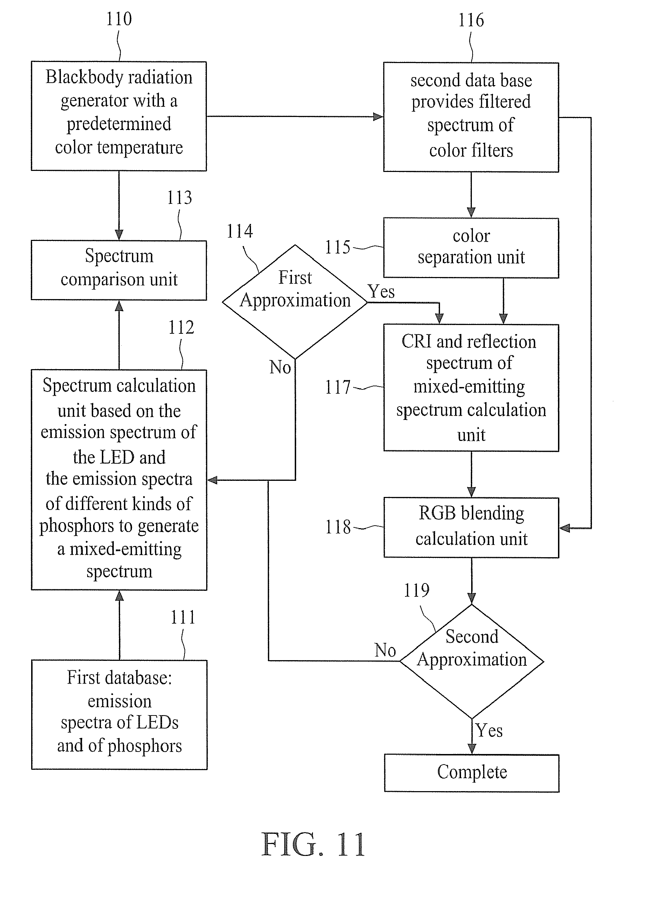

FIG. 11 disclose a system diagram for configuring a white light LED with high CRI. A blackbody radiation generator 110 with a predetermined color temperature generates a visible spectrum radiated from a blackbody with a predetermined color temperature. The color temperature ranges from 1500K to 8000K.

A first database 111 is adopted to store various emission spectra of LEDs or of phosphors. The emission range of an LED with UVA light is 365nm - 380nm, while the emission range of an LED with violet light is 380nm - 420nm and the emission range of an LED with blue light is 420nm - 470nm. The wavelength of an emission generated by a phosphor is between 480nm and 580nm. The phosphor can be silicates or oxides, such as:

$$CaSc_2O_4:Ce(516nm),$$

$$(MgCaSrBa)_2SiO_4:Eu(525nm),$$

$$Ca_3Sc_2Si_3O_{12}:Ce(455\text{-}507nm),$$

$$(Ca_{1.47}Mg_{1.5}Ce_{0.03})(Sc_{1.5}Y_{0.5})Si_3Ol_2(455nm), \text{ or}$$

$$(Ca_{2.97}Ce_{0.03})Sc_2(Si,Ge)_3O_{12}.$$

The phosphor can be nitrides or sulfides, and its emission wavelength is between 600nm and 650nm such as:

$$CaAlSiN_3:Eu(650nm),$$

$$(CaEu)AlSiN_3(648nm),$$

$$(SrCa)AlSiN_3:Eu(630nm), \text{ or}$$

$$SrGa_2S_4:Eu(645nm).$$

Those skilled in the art may utilize other kinds of phosphor to implement the present invention such as garnetite or nitrogen oxides.

A spectrum calculation unit 112 collects from the first database 111 the emission spectrum of the LEDs and the emission spectra of two kinds of phosphors. The concentrations of the phosphors may be thus determined and adjusted. The spectrum calculation unit 112 then generates a mixed-emitting spectrum.

The spectrum comparison unit 113 determines the similarity by comparing the mixed-emitting spectrum with the visible spectrum radiated from a blackbody with a predetermined color temperature. The outcome of the comparison is the first approximation 114. If the first approximation indicates Yes, the process moves on. If the first approximation indicates No, the process returns to the spectrum calculation unit 112 and reselects the concentration of other phosphors until the first approximation indicates Yes.

The second data base 116 stores and provides filtered spectra of color filters. The calculated mixed-emitting spectrum becomes red, green, and blue colors after being provided to the color separation unit 115. The data of such three colors is provided to the color saturation calculation unit 117 and RGB blending calculation unit 118 to calculate the color saturations of the three colors after color separation and the chromaticity coordinate values of a white light based on the combination of such three colors after color separation.

The result of the calculation is then provided to the second approximation 119 to determine whether such color saturations and such chromaticity coordinate values meet a predetermined requirement. When one of the conditions fails the predetermined requirement, the step returns to the spectrum calculation unit 112 to adjust the concentration of phosphors such that the results provided by the color saturation calculation unit 117 and the RGB blending calculation unit 118 meet a predetermined requirement. The conditions of color saturations can be predetermined to be 90% of NTSC, 95% of NTSC, or 100% of NTSC. The white lights after blending may become a standard white light or a white light that meets a particular commercial specification; wherein the particular commercial specification may be a requirement that the chromaticity coordinate values of a white light meets the color temperature of a blackbody radiation, such as a color temperature of 6500K or 6000K.

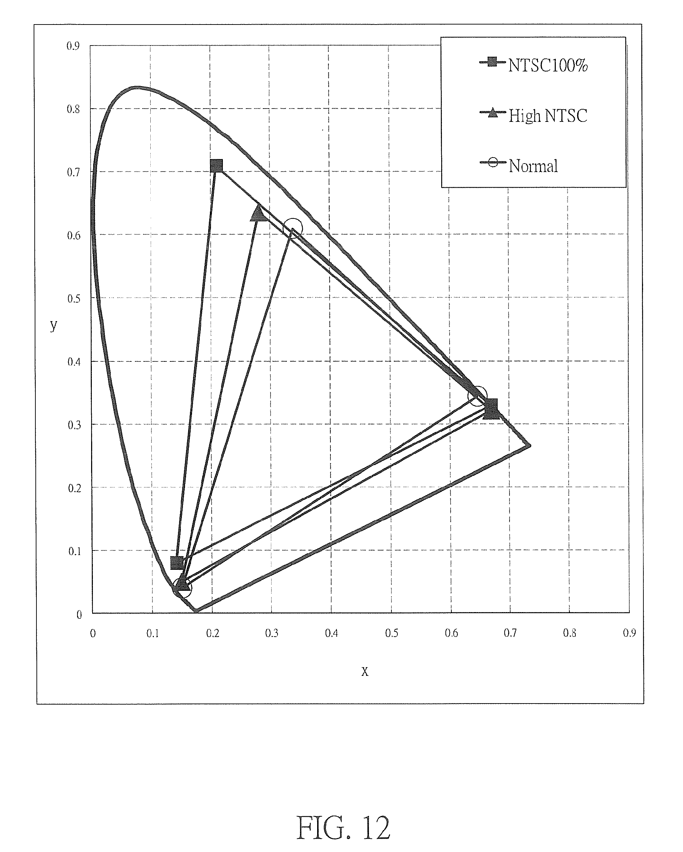

FIG. 12 illustrates an LED BLU with high NTSC, the NTSC standard, and a CIE 1931 chromaticity coordinate values of an ordinary LED. When the method of system of the present invention is applied, the color saturation is improved when comparing with the light source based on an ordinary white light LED. In FIG. 12, the RGB applying the present invention is marked by triangles, and the color saturations can be represented by the area of the triangles. Comparing the area of triangles and the area formed by o, the area of triangles is closer to the area from by squares. Accordingly, the present inventions provide a better color saturation.

The embodiment utilizes a mixture of two phosphors. Three kinds of phosphors may be used as well. When necessary, more than three kinds of phosphors may be used.

The measurement of the present invention is to determine the spectrum radiated from a blackbody with a predetermined temperature by Planck's formula. Based on the spectrum determined, the first approximation concentration of multiple phosphors may be calculated, and the emission spectrum of an LED after blending can be calculated in light of the first approximation concentration of multiple phosphors. The color saturation may be calculated after the color filters in accordance with the emitting spectrum and the chromaticity coordinate values of a white light after a mixture to adjust the concentration of phosphors or to reselect other phosphors.

The present invention has several advantages in reducing the developing time when multiple phosphors are used and in calculating the proportionality relation between the phosphors more efficiently.

The embodiments of the present invention are intended to be illustrative only. Those skilled in the art may devise numerous alternative embodiments without departing from the scope of the following claims. Accordingly, the scope of the present invention shall be not limited to embodiments disclosed but shall be properly determined by the claims set forth below.

**Claims**

1. A method for configuring high an LED BLU (Back Light Unit) with high NTSC comprising:

   calculating a standard spectrum;
   providing an emission spectrum of an LED, a first phosphor, and a second phosphor;
   adjusting the concentration of the first phosphor and the second phosphor to generate a first mixed-emitting spectrum similar to the standard spectrum wherein the first mixed-emitting spectrum is mixed by the LED, the first phosphor, and the second phosphor;
   providing a chromaticity coordinate with RGB chromaticity coordinate values of the first mixed-emitting spectrum after the color separation by a color filter and calculating an area formed by the RGB chromaticity coordinate values; and
   calculating a white light chromaticity coordinate value based on a combination of the RGB chromaticity coordinate values.

2. The method of Claim 1, wherein the standard spectrum calculated is based on Planck's Formula.

3. The method of Claim 1 or 2, wherein the first phosphor is $CaSc_2O_4$:Ce, $(MgCaSrBa)_2SiO_4$:Eu, $Ca_3Sc_2Si_3O_{12}$:Ce, $(Ca_{1.47}Mg_{1.5}Ce_{0.03})(Sc_{1.5}Y_{0.5})Si_3OI_{12}$, or $(Ca_{2.97}Ce_{0.03})Sc_2(Si,Ge)_3)O_{12}$.

4. The method of any of claims 1 to 3, wherein the second phosphor is $CaAlSiN_3$:Eu, $(CaEu)AlSiN_3$, $(SrCa)AlSiN_3$:Eu, or $SrGa_2S_4$:Eu.

5. The method of any of claims 1 to 4, further comprising a third phosphor and an emission spectrum of the third phosphor.

6. A method for configuring an LED BLU (Back Light Unit) with high NTSC comprising:

calculating an emission spectrum radiated from a blackbody with a first color temperature;
adjusting concentration of multiple phosphors to generate a spectrum of a mixed-emitting LED is similar to the emission spectrum radiated from the blackbody;
separating the spectrum of the mixed-emitting LED to RGB chromaticity coordinate values by a color filter;
calculating an area formed by the RGB chromaticity coordinate values and determining whether the area is similar to NTSC; and
determining whether a white light chromaticity coordinate values based on the combination of the RGB chromaticity coordinate values is similar to a white light with an first color temperature.

7. The method of Claim 6, wherein the emission spectrum radiated from a blackbody is based on Plank's Formula.

8. The method of Claim 6 or 7, wherein the first phosphor is $CaSc_2O_4$:Ce, $(MgCaSrBa)_2SiO_4$:Eu, $Ca_3Sc_2Si_3O_{12}$:Ce, $(Ca_{1.47}Mg_{1.5}Ce_{0.03})(Sc_{1.5}Y_{0.5})Si_3OI_{12}$, or $(Ca_{2.97}Ce_{0.03})Sc_2(Si,Ge)_3O_{12}$.

9. The method of any of claims 6 to 8, wherein the second phosphor is $CaAlSiN_3$:Eu, $(CaEu)AlSiN_3$, $(SrCa)AlSiN_3$:Eu, or $SrGa_2S_4$:Eu.

10. A system for configuring an LED BLU (Back Light Unit) with high NTSC comprising:

a first database to provide an emission spectrum of an LED, an emission spectrum of a first phosphor, and an emission spectrum of a second phosphor;
a standard color temperature spectrum generator to generate a visible spectrum radiated from a blackbody with a first color temperature;
a first blending unit to calculate a mixed-emitting spectrum of the LED, the first phosphor, and the second phosphor stored in the first database, wherein the mixed-emitting spectrum is a first mixed-emitting spectrum;
a spectrum comparison unit to compare the first mixed-emitting spectrum with the standard spectrum generated by the standard color temperature spectrum generator;
a second data base to store filtered spectra by a color filter;
a filtering unit to calculate RGB chromaticity coordinate values of the first mix-emitting spectrum based on the filtered spectra of the color filter stored in the second data base;
a color saturation calculation unit to calculate an area formed by the RGB chromaticity coordinate values of the first mix-emitting spectrum;
a second blending unit to calculate a white light chromaticity coordinate values based on the combination of the RGB chromaticity coordinate values.

11. The system of Claim 10, wherein the emission spectrum radiated from a blackbody is calculated based on Planck's formula.

12. The system of Claim 10 or 11, wherein the first phosphor is $CaSc_2O_4$:Ce, $(MgCaSrBa)_2SiO_4$:Eu, $Ca_3Sc_2Si_3O_{12}$:Ce, $(Ca_{1.47}Mg_{1.5}Ce_{0.03})(SC_{1.5}Y_{0.5})Si_3OI_{12}$, or $(Ca_{2.97}Ce_{0.03})Sc_2(Si,Ge)_3O_{12}$.

13. The system of any of claims 10 to 12, wherein the second phosphor is $CaAlSiN_3$:Eu, $(CaEu)AlSiN_3$, $(SrCa)AlSiN_3$:Eu, or $SrGa_2S_4$:Eu.

14. The system of any of claims 10 to 13, further comprising a third phosphor and an emission spectrum of the third phosphor.

FIG. 1

FIG. 2

31 — adjust the concentration of multiple phosphors such that a spectrum of the mixed emitting LED is similar to a spectrum radiated from a blackbody with a first color temperature.

32 — determine RGB chromaticity coordinate values representing the spectrum of the mixed-emitting LED after a color separation by a color filter and the area formed by a white light chromaticity coordinate values based on the combination of the RGB chromaticity coordinate values.

## FIG. 3

41 — calculate a standard spectrum

42 — provide a emission spectrum of a LED, a emission spectrum of a first phosphor, and a emission spectrum of a second phosphor

43 — adjust the concentrations of the first phosphor and the second phosphor based on the standard spectrum to generate a first mixed-emitting spectrum similar to the standard spectrum.

44 — determine the area formed by a RGB chromaticity coordinate values of the first mixed-emitting spectrum after a color separation by a color filter.

45 — calculates chromaticity coordinate values of a white light based on the combination of RGB colors

## FIG. 4

First Data Base —51

Second Data Base —55

First blending Unit —52

filtering unit —56

spectrum comparison unit —54

Standard color temperature spectrum generator

53

color saturation calculation unit

57

second blending unit

58

FIG. 5

62 —⌐ provide an emission spectrum
of LED, an emission spectrum
of the first phosphor, and an
emission spectrum of the
second phosphor.

61

based on Planck's formula to
calculate a visible spectrum
radiated from a blackbody with a
predetermined color temperature

calculate a mixed-emitting
spectrum of the mixture of
LED, the first phosphor,
and the second phosphor.

63

64 —⌐ determine the area formed by the red, green,
chromaticity coordinate values of the
first mix-emitting spectrum after a red, green,
blue color separation by a color filter.

65 —⌐ calculate the chromaticity coordinate
values of a white light based on the
combination of the chromaticity coordinate
values of the red, green, blue colors.

FIG. 6

72

First data base, the emission spectrum of the LED, and the emission spectra of phosphors.

71

Blackbody radiation generator(71) with a predetermined color temperature

76

Reselect phosphors

73

spectrum calculation unit generates a mixed-emitting spectra based on the emission spectra of LED and different kinds of concentration of the phosphors

74

Spectrum comparison unit

No

77

Adjust the concentrations of phosphors

Yes

Complete

FIG. 7

**FIG. 8**

A: Emission spectrum of LED
B: Emission spectrum of first phosphor
C: Emission spectrum of second phosphor
D: Mixed-emitting spectrum

FIG. 9

100

101 ─╮ ┌─────────────────────────────┐
        │ A first database is adopted │
        │ to store various emission   │
        │ spectra of LED or phosphors │
        └─────────────────────────────┘

┌─────────────────────┐
│ Blackbody radiation │
│ generator with a    │
│ predetermined       │
│ color temperature   │
└─────────────────────┘

109
┌──────────────────────┐
│ Reselect phosphors   │
└──────────────────────┘

102
┌──────────────────────────────────┐
│ A spectrum calculation unit      │
│ generate a mixed-emission        │
│ spectrum based on the            │
│ emission spectrums of LED        │
│ and different kinds of           │
│ concentration of the phosphors   │
└──────────────────────────────────┘

103
┌──────────────────────────┐
│ A second database stores │
│ and provides filtered    │
│ spectra of color filters │
└──────────────────────────┘

104
┌─────────────────────┐
│ calculate the color │
│ saturations of RGB  │
│ colors after        │
│ color separation    │
└─────────────────────┘

105
┌──────────────────────────┐
│ Calculate the            │
│ chromaticity coordinate  │
│ values of a white        │
│ light mixed by           │
│ RGB colors after         │
│ color separation         │
└──────────────────────────┘

108
┌──────────────────────┐
│ Adjust the           │
│ concentrations       │
│ of the phosphors     │
└──────────────────────┘

107
◇ Comparison unit ◇ —— No

Yes

┌──────────────┐
│ Complete     │
└──────────────┘

FIG. 10

FIG. 11

FIG. 12

**EUROPEAN SEARCH REPORT**

Application Number

EP 09 17 2652

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2006/226759 A1 (MASUDA MASATSUGU [JP] ET AL) 12 October 2006 (2006-10-12) <br> * paragraphs [0008], [0017] - [0018], [0034], [0062] * <br> * paragraph [0071] - paragraph [0079]; figures 5,6; example 9; table 4 * <br> * paragraph [0088] - paragraph [0091]; example 10; table 5 * <br> * paragraph [0092] - paragraph [0097]; examples 12,15; table 6 * <br> ----- | 1-14 | INV. <br> G02F1/13357 <br> H01L33/50 |
| X | EP 1 566 848 A2 (LUMILEDS LIGHTING LLC [US]) 24 August 2005 (2005-08-24) <br> * paragraph [0030] - paragraph [0035]; figure 8 * <br> * paragraphs [0036], [0039]; figure 11 * <br> ----- | 1-14 | |
| | | | TECHNICAL FIELDS SEARCHED (IPC) <br><br> G02F <br> H01L <br> C09K |

The present search report has been drawn up for all claims

| Place of search | Date of completion of the search | Examiner |
|---|---|---|
| Munich | 15 January 2010 | Frank, Wolfgang |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

## ANNEX TO THE EUROPEAN SEARCH REPORT
## ON EUROPEAN PATENT APPLICATION NO.

EP 09 17 2652

This annex lists the patent family members relating to the patent documents cited in the above-mentioned European search report.
The members are as contained in the European Patent Office EDP file on
The European Patent Office is in no way liable for these particulars which are merely given for the purpose of information.

15-01-2010

| Patent document cited in search report | Publication date | Patent family member(s) | Publication date |
|---|---|---|---|
| US 2006226759 A1 | 12-10-2006 | JP 2007049114 A | 22-02-2007 |
| EP 1566848 A2 | 24-08-2005 | JP 2005244226 A<br>US 2005184638 A1 | 08-09-2005<br>25-08-2005 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20060290624 A
- TW 200627678
- TW 200830580